# EUROPÄISCHE PATENTSCHRIFT

(11) **EP 0 642 298 B1**
(45) Veröffentlichungstag und Bekanntmachung des Hinweises auf die Patenterteilung: **02.07.1997**
(21) Anmeldenummer: 94113924.8
(22) Anmeldetag: 05.09.1994
(51) Int. Cl.: H05K 3/34, B23K 1/00

(54) **Verfahren zum Löten von oberflächenmontierbaren elektronischen Bauelementen auf Leiterplatten**
Method of soldering of electronic components for surface mounting on circuit boards
Méthode de soudage de composants électroniques pour montage à la surface des plaques de circuit

(30) Priorität: 08.09.1993 DE 4330467
(43) Veröffentlichungstag der Anmeldung: 08.03.1995
(73) Patentinhaber: Siemens Nixdorf Informationssysteme AG, 33106 Paderborn (DE)
(72) Erfinder: Dederer, Dipl.-Ing. Günter, D-81739 München (DE)
(74) Vertreter: Fuchs, Franz-Josef, Dr.-Ing.

(56) Entgegenhaltungen:
- EP-A- 0 130 643
- EP-A- 0 378 113
- EP-A- 0 420 050
- EP-A- 0 534 161

## Beschreibung

Die Erfindung betrifft ein Verfahren zum Auflöten von oberflächenmontierbaren elektronischen Bauelementen auf Leiterplatten mit vorbeloteten Anschlußflecken, wobei in der Regel das Lot umgeschmolzen ist. Dies geschieht mittels einer Lötvorrichtung mit mindestens einer Bügelelektrode (auch Thermode genannt), die durch elektrische Widerstandswärme erhitzbar ist und mittels der eine Kraft auf die Anschlußbeinchen des Bauelementes während der Lötphase ausgeübt wird.

Lötvorrichtungen mit sogenannten Thermoden zum Reflowlöten (Bügel-Löten) sind verschiedentlich bekannt. Dabei gibt es entsprechend der Form der elektronischen Bauelemente Vorrichtungen mit zwei parallel einander gegenüberliegenden oder mit vier paarweise einander gegenüberliegenden Bügelelektroden. Diese Vorrichtungen dienen dazu, Bauelemente mit einer Vielzahl von Anschlußbeinchen auf eine Leiterplatte bzw. auf die dazu vorgesehenen Anschlußflecken des auf der Leiterplatte befindlichen Leiterbildes aufzulöten. Bei der automatischen Bestückung ist in der Regel eine zentral angeordnete Saugpipette vorhanden und die Lötbügel sind so angeordnet, daß sie auf jeweils eine Reihe von Anschlußbeinchen plaziert werden können.

Die durch elektrische Widerstandserwärmung beheizte Bügelelektrode ist das zentrale Bauteil der Lötvorrichtung. Durch sie wird die nötige Energie für die Lötung eingebracht. Darüberhinaus ist es bekannt, eine Kraft auf die Bügelelektrode und folglich auch auf die Anschlußbeinchen des Bauelementes auszuüben, so daß diese an oder in das auf den Anschlußflecken befindliche Lot gedrückt werden.

Aus dem Artikel "Impulslöten - die Alternative für SMDs" von G. Zschimmer in der Zeitschrift Elektronik, Bd. 35, Nr. 25, 12.12.1986, München, Seiten 57 bis 64 ist ein entsprechendes Verfahren bekannt. Das hier als Impulslöten bezeichnete Verfahren geschieht mit einem Lötadapter, der einer Bügelelektrode entspricht. Eine definierte Kraft wirkt von Anfang an, so daß die Lötpartner bereits im kalten Zustand aneinandergepreßt werden. Eine Entlastung von der anliegenden Kraft geschieht erst wieder wenn das Lot erstarrt ist. Durch die Anpreßkraft wird ausgeschlossen, daß ein Spalt zwischen Anschlüssen und Substrat mit Lot gefüllt wird. Da hierfür eine Standardplattierung ausreicht, wird keinerlei Lot oder Lötpaste zugeführt.

Die europäische Patentanmeldung EP-A-0 420 050 offenbart ein entsprechendes Lötverfahren bei dem nach dem Aufschmelzen des Lotes und dem Nachdrucken der Anschlußbeinchen in das flüssige Lot eine definierte Verringerung der auf die Bügelelektrode bzw. auf die Anschlußbeinchen ausgeübten Kraft zur Ausbildung einer definierten Lotschicht zwischen den Anschlußbeinchen und den zugehörigen Anschlußflecken vorgenommen wird.

Beim Löten von hochpoligen SMD-Bauteilen (oberflächenmontierbare Bauteile) werden die durch Biegen geformten, vorwiegend vorbeloteten Anschlußbeinchen mit gleichmäßiger Kraft auf die beloteten und umgeschmolzenen Anschlußflecken der Leiterplattenoberfläche niedergedrückt und mittels Stromimpuls-Wärme nach dem Prinzip des Wiederaufschmelzverfahrens (Reflowlöten) durch Löten aller Anschlußbeinchen in einem Arbeitsgang mit den Anschlußflecken verbunden. Ein wesentlicher Nachteil dabei besteht darin, daß durch die gewählte hohe Auflagekraft des Lötwerkzeuges (Thermode) und der unterschiedlichen Höhe der Lotdepots auf der Vielzahl von Anschlußflecken es zur Dejustierung/Deplazierung einzelner Anschlußbeinchen oder zur Deformation oder Delamination an Anschlußflecken kommen kann. Durch die teils balligen Oberflächen der Lotdepots werden Querkräfte erzeugt, wodurch ein Abgleiten einzelner Anschlußbeinchen vom entsprechenden Anschlußflecken vor bzw. während des Lötvorganges vorkommen kann. Dieses Verschieben der Anschlußbeinchen führt dann oft zu Kurzschlüssen mit den benachbarten Anschlüssen. Die Reparatur ist sehr aufwendig oder gar nicht durchzuführen. Weitere nachteilige Auswirkungen kann die Welligkeit der Leiterplatte mit sich bringen. Ist die Leiterplatte spürbar gewellt, so kann das Lötwerkzeug nicht gleichzeitig mit allen Anschlußbeinchen in Berührung kommen. Erst nach dem Aufschmelzen des Lotes an den höheren Anschlußflecken werden die tieferliegenden Anschlüsse durch das Lötwerkzeug erwärmt und mit dem entsprechenden Anschlußflecken verbunden. Dieses zeitlich unterschiedliche Ankoppeln der Anschlußbeinchen erhöht zu Beginn des Lötverfahrens nach dem Aufbau der maximalen Kraft die spezifische Flächenpressung der am höchsten liegenden Anschlußbeinchen unter voller Krafteinwirkung durch das Thermoden-Werkzeug.

Als Lösungsvorschlag gegen ein Abkippen bzw. Wegrutschen eines Anschlußbeinchens ist bereits der Einsatz eines entsprechend drehbar gelagerten Lötbügels bekannt. Ein derartiger Lötbügel kann die eigentlich parallel zur Reihe der Anschlußflecken bzw. Anschlußbeinchen liegende Lötkante (seine untere Kante) in geringen Grenzen aus dieser Parallelität heraus positionieren. Hier liegt die maximale Kraft anfangs meist nur auf zwei Anschlußbeinchen. Ein oben beschriebenes Abgleiten kann nicht ausgeschlossen werden.

Ein wesentlicher Nachteil im Stand der Technik ist jedoch die konstant bleibende Krafteinstellung während des gesamten Lötvorganges. Das Aufsetzen auf die Anschlußbeinchen mit einem bereits heißen Lötwerkzeug konnte die Fehlerquelle, die zum Abrutschen der Beinchen führt, nicht ausschalten.

Der Erfindung liegt die Aufgabe zugrunde ein Lötverfahren für oberflächenmontierbare Bauelemente zu schaffen, das mittels einer widerstandsbeheizten Bügelelektrode während des Lötvorganges eine Kraft auf die Anschlußbeinchen von elektronischen Bauelementen ausübt, wobei keinerlei Deplazierung von Anschlußbeinchen durch Abgleiten auf der Lotschicht eines Anschlußfleckens und keine übermäßige Belastung einzelner Anschlußflecken vorkommt.

Die Lösung dieser Aufgabe geschieht durch den Gegenstand des Anspruches 1.

Der Erfindung liegt die Erkenntnis zugrunde, daß die stufenweise oder kontinuierliche Erhöhung der Kraft, die der Lötbügel während des Lotvorganges beim Aufschmelzen des Lotes auf die Anschlußbeinchen ausübt, eine dosierte, der Anzahl der niedergedrückten Anschlußbeinchen bezogene gleichbleibende Anpreßkraft erzeugt. Dabei wird vorausgesetzt, daß eine exakte Positionierung der Anschlußbeinchen über den jeweiligen Anschlußflecken vorliegt und der Lötbügel starr ist und sich lediglich senkrecht zur Reihe der Anschlußbeinchen nach oben und unten bewegen läßt. Die Lötkante ist ebenfalls parallel zu der Leiste der Anschlußbeinchen. Der Erhöhung der Kraft während des Aufschmelzvorganges geht das Anlegen einer geringen Kraft voraus, um den Lötbügel mit seiner Lötkante geringfügig an die Anschlußbeinchen anzudrücken, die auf dem zu dieser Zeit noch harten Lot auf den Anschlußflecken aufsitzen. In der Realität wird durch unterschiedliche Lothöhe bzw. Welligkeit der Leiterplatte nur eine geringe Anzahl von Anschlußbeinchen Kontakt zum Lot haben, so daß diese Anschlußbeinchen diese geringe anfängliche Kraft vollständig aufnehmen. Nachfolgend wird die Größe der aufgebrachten Kraft dem Abschmelzvorgang derart angepaßt, daß die auf ein Anschlußbeinchen bezogene Kraft annähernd konstant bleibt. Der anfänglich auf einer geringen Anzahl von Anschlußbeinchen beispielsweise ein bis zwei Stück aufsitzende Lötbügel sorgt durch den entsprechenden körperlichen Kontakt für das Aufschmelzen des Lotes dieser wenigen Anschlußbeinchen. In Anschluß daran wird sich die Zahl der Anschlußbeinchen erhöhen, auf denen der Lötbügel aufliegt, dann wiederum die entsprechende Energie zum Aufschmelzen des jeweiligen Lotdepots durch Warmeleitung geliefert und nach und nach die Vielzahl von Anschlußbeinchen in das entsprechende aufgeschmolzene Lotdepot hineindrückt. Somit ist gewährleistet, daß zu keiner Zeit eine überhöhte Kraft auf eine geringe Anzahl von Anschlußbeinchen ausgeübt wird, während das zugehörige Lotdepot noch nicht aufgeschmolzen ist. Folglich wird ein Abgleiten von Anschlußbeinchen und eine Beschädigung, beispielsweise durch Delaminierung, durch einzelne überbelastete Anschlußflecken verhindert.

In Anschluß an die Temperaturhaltephase auf dem Niveau der Schmelztemperatur bzw. auf einem Niveau einer überhöhten Temperatur wird die maximal eingestellte Kraft auf eine Restkraft verringert, bis die Temperatur am Lötort ausreichende Festigkeit der Lötungen gewährleistet. Durch diese Maßnahme, bei der die maximal eingestellte Kraft nicht bis zum Schluß des Lötvorganges gehalten wird können Spannungen im erstarrten Lot abgebaut werden.

Eine vorteilhafte Ausgestaltung der Erfindung sieht die Regelung von Temperatur und Kraft vor, so daß bei Vorgabe einer Sollkurve im Temperatur/Zeit- oder Kraft/Zeit-Diagramm jeweils linienförmige Kurvenverläufe möglich sind. Dies dient nicht nur der exakten Kontrolle der Parameter, sondern ermöglicht auch eine zügige Verfahrensführung, wobei beispielsweise beim Abkühlen von Lötstellen durch Anblasen mittels eines Inertgases, beispielsweise Stickstoff, nicht nur der Effekt der Antioxidation ausgenützt wird, sondern auch eine gezielte Abkühlung möglich ist.

Im folgenden wird anhand von schematischen Figuren ein Ausführungsbeispiel beschrieben.

Die Figur 1 zeigt den prinzipiellen Aufbau einer Anordnung innerhalb einer Lötvorrichtung.

Die Figur 2 zeigt das Phänomen des Abgleitens eines Anschlußbeinchens, wenn ein Lötbügel mit überhöhter Kraft aufsetzt.

Figur 3 und Figur 4 zeigen den zeitlichen Verlauf von Temperatur und Kraft bei einem entsprechenden Lötvorgang.

Der prinzipielle Aufbau von Bügellötmaschinen ist bekannt und wird hier nicht naher beschrieben. Zwischen dem maschinellen Aufbau und dem Führungssystem des Thermoden-Halters ist zur Kraftregelung ein Kraftmeßsystem mit Kraftsensor eingesetzt. Der Thermoden-Halter ist auf ein Führungssystem aufgesetzt. Der Thermoden-Halter trägt die Thermode. Die Thermode ist beispielsweise als Lötbügel ausgeführt, kann eine Keramikbeschichtung aufweisen und beinhaltet zur Temperaturregelung ein Thermoelement. Der Lötbügel kann auch im wesentlichen aus Metall bestehen, wobei eine Keramikplatte eingesetzt ist oder es wird ein vollkeramisches Element mit Heizwiderstand verwendet. Ein Thermoelement bzw. Temperatursensor ist jeweils vorhanden.

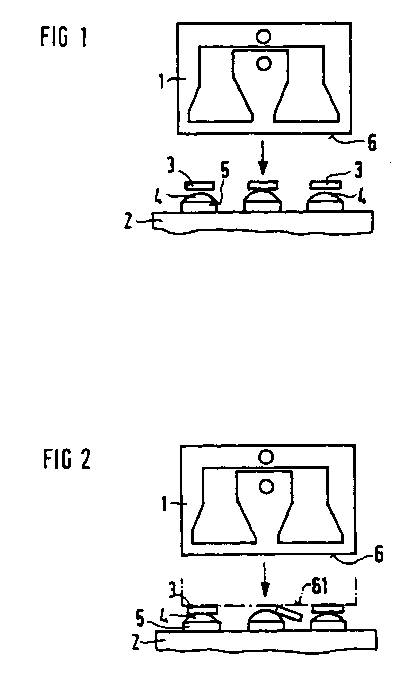

Die Figur 1 zeigt eine Bügelelektrode 1 mit entsprechenden Befestigungslöchern und inneren Aussparungen. An ihrer Unterseite befindet sich die Lötkante 6. Die Bügelelektrode 1 kann in Richtung des Pfeiles auf eine Reihe von Anschlußbeinchen 3 hinbewegt werden, wobei eine Kraft auf diese ausgeübt werden kann. Bei der Bewegung in Gegenrichtung wird entsprechend entlastet. Die auf der Leiterplatte 2 befindlichen Anschlußflecken 5 sind wie hier angedeutet mit unterschiedlich hohen Lotdepots 4 versehen, auf die das mittlere dargestellte Anschlußbeinchen 3 auf das Lotdepot 4 aufgesetzt hat. Das zugehörige elektronische Bauelement ist nicht dargestellt. Würde eine von Anfang an eingestellte hohe Kraft über die Bügelelektrode 1 auf die Anschlußbeinchen 3 wirken, so würde zu Anfang, wenn das Lot 4 noch nicht aufgeschmolzen ist, die gesamte Kraft auf dem mittleren Anschlußbeinchen 3 lasten, was zu einem Abgleiten oder zu einer Delaminierung des Anschlußfleckens bezüglich der Leiterplatte führen kann. Weitere Ursachen des Abgleitens sind beispielsweise nicht exakt ausgerichtete oder verdrehte Anschlußbeinchen 3.

In Figur 2 ist das besagte Abgleiten am Beispiel des mittleren dargestellten Anschlußbeinchens 3 skizziert worden. Die angedrückte Bügelelektrode 1 ist in diesem Fall so plaziert, daß die Lötkante 61 an den Anschlußbeinchen 3 anliegt und diese andrückt.
Erfindungsgemäß ist die Bügelelektrode 1 starr und kann lediglich mit einer zur Leiterplatte parallelen Lötkante 6, 61 zum Andrücken in Richtung auf die Leiterplatte 2 bewegt werden oder zum Entlasten in Gegenrichtung zurückgezogen werden.

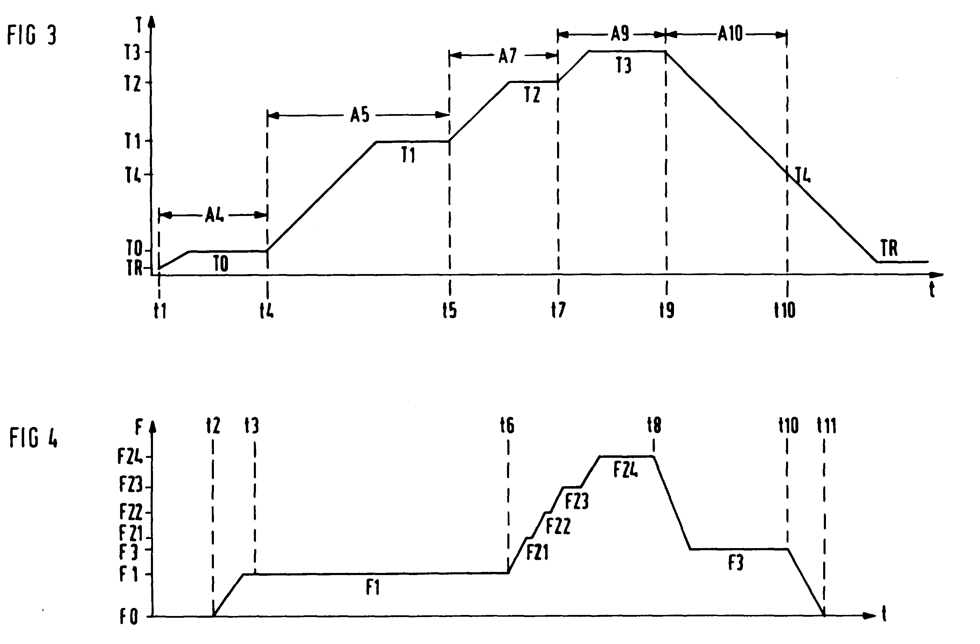

In den Figuren 3 und 4 sind bei jeweils korrespondierender Zeitachse der geregelte Verlauf der Temperatur und der Kraft skizziert. Die Temperatur entspricht idealerweise der am Ort der Lötung und wird über Temperatursensoren, wie beispielsweise Thermoelemente, möglichst nahe an dem Ort der Lötung gemessen. Die Kraft wird über eine der Bügelelektrode 1 vorgeschaltete Kraftmeßzelle ermittelt und wirkt über die Bügelelektrode 1 in Richtung auf die Reihe der Anschlußbeinchen 3.

Der Verfahrensablauf sieht vor, das Temperatursystem bei einer geringen Temperaturerhöhung bei der Zeit t2 vollautomatisch zu testen und dann die Bügelelektrode 1 auf die Anschlußbeinchen 3 des elektronischen Bauteils abzusenken und eine geringe Kraft F1 aufzubauen. Nach einer kurzen Verweilzeit entsprechend dem Abschnitt A4, der bis zur Zeit t4 reicht, wird das Kraft- und Temperatur-System vollautomatisch getestet. Bei der Zeit t2 wird ein Startsignal gegeben, woraufhin auf die geringe Kraft F1 hochgefahren wird, die bei ca. 10 bis 20 % der maximalen Kraft F24 liegt. Dies entspricht je nach fine-pitch-Abmessung ungefähr einem Wert von 0,5 bis 1 N pro Beinchen. Bis zur Zeit t3 wird das Kraftsystem getestet. In Anschluß an den Abschnitt A4 wird die Temperatur auf T1 erhöht. Dies dient der Aktivierung des Flußmittels. Der folgende Abschnitt A7 beinhaltet die Temperaturerhöhung auf T2 (Schmelztemperatur). In diesem Bereich wird das Lotmaterial 4 verflüssigt. Eine folgende Temperaturüberhöhung von T2 auf T3 im Abschnitt A9 stellt den eigentlichen Lötvorgang dar. Der Abschnitt A10 entspricht der Erstarrungsphase und A11 der der vollständigen Abkühlung auf Raumtemperatur TR.

Die erfindungsgemäße Erhöhung der Kraft F beginnt in dem Abschnitt A7 in dem das Lot 4 plastisch wird, d.h. beim Erreichen der Schmelztemperatur T2. Wie in Figur 4 dargestellt wird die Kraft mit Erreichen der horizontalen Linie bei T2 in mehreren Stufen geregelt erhöht. Die Temperatur wird um weitere ca. 30 bis 60° Grad über die Schmelztemperatur T2 angehoben, und gleichzeitig die maximale Kraft F24 am Lötwerkzeug eingeregelt. Vor dem Absinken der Temperatur wird die Kraft in einer oder in mehreren Stufen abgesenkt, was im Bereich nach der Zeit t8 dargestellt ist. Um Spannungen im noch nicht erstarrten Lot auszugleichen wird eine Restkraft F3 bis zum vollständigen Erstarren des Lotes 4 gehalten. In Anschluß daran wird die Kraft auf Null abgebaut und der Lötkopf wird abgehoben.

Die Temperaturüberhöhung im Abschnitt A9 ist bei Lötvorgängen zum einen üblich und hat den besonderen Zweck den Schmelzvorgang und die Legierungsbildung in kurzer Zeit zu ermöglichen. Die Anzahl der Kraftstufen kann je nach Lötaufgabe frei gewählt und durch Versuche optimiert werden. Die Kraft- und Temperaturkurve läuft geregelt über entsprechende Software und einen Rechner.

Nachdem im Abschnitt A5 durch die Kraft F1 die Lötpartner soweit möglich zusammengefügt wurden wird beginnend mit der Zeit t6 das Abschmelzen der ersten Lotdepots 4 erfolgen. Die stufenweise Erhöhung der aufgebrachten Kraft über F21, F22, F23 bis zur maximalen Kraft F24 ist damit anschaulich verbunden mit einer auf die Anzahl der kraftbeaufschlagten schlußbeinchen 3 verteilten und je Anschlußbeinchen 3 annähernd konstanten Kraft. Ein Abgleiten durch ein zu stark belasteten Anschlußbeinchens 3 wird somit unmöglich.

Die Gesamtzeit eines Lötvorganges ist von der Beinchenanzahl des entsprechenden elektronischen Bauteiles abhängig. Diese Beinchenzahl kann im Bereich von mehreren Hundert liegen. Beispielsweise benötigt man für Abschnitt A4 für einen Lötvorgang ca. 1 Sekunde. Für Abschnitt A5 2 bis 4 Sekunden, für Abschnitt A7 mit A9 ca. 3 bis 8 Sekunden und für den Abschnitt A10 und A11 10 bis 20 Sekunden. Auf der Temperaturachse wird zum einen die Raumtemperatur TR mit ca. 20° Grad angesetzt. Die Temperatur T0 liegt bei ca. 50° Grad. Die zur Aktivierung des Flußmittels nötige Temperatur T1 liegt zwischen 100 und 140° Grad. Die Schmelztemperatur T2 liegt bei ca. 190° Grad (183° Grad eutektischer Schmelzpunkt, je nach Lotmaterial variabel). Die maximale Temperatur T3 liegt im Bereich von 220 bis 250° Grad. Die nach dem Abkühlen erreichte Temperatur T4 von ca. 120° Grad löst das Absenken der Restkraft F3 zu Null aus. Im Abschnitt A11 kühlt das Lötwerkzeug auf Raumtemperatur TR ab.

Werden elektronische Bauelemente mit beispielsweise vier Reihen von Anschlußbeinchen 3 aufgelötet, so ist für jede Seite bzw. für jede Reihe eine Bügelelektrode 1 mit eigenem Kraftmeß-bzw. Kraftregelsystem notwendig. Entsprechendes gilt für die Temperaturregelung. Durch den Einsatz einer Temperaturregelung ist zu jeder Zeit die aktuell anliegende Temperatur erkennbar.

## Patentansprüche

1. Verfahren zum Löten von oberflächenmontierbaren elektronischen Bauelementen mit Anschlußbeinchen (3) auf Leiterplatten (2), wobei mindestens eine Lötvorrichtung verwendet wird, die eine durch elektrische Widerstandswärme erhitzbare, starre und senkrecht zur Reihe der Anschlußbeinchen nach oben und unten bewegbare Bügelelektrode (1) zum Reflow-Löten enthält, über die eine auf die Anschlußbeinchen (3) des Bauelementes wirkende und auf zugehörige Anschlußflecken (5) gerichtete Andruckkraft in Abhängigkeit von der Temperatur am Lötort geregelt aufgebracht wird, mit folgenden Schritten:
- die Bügelelektrode (1) setzt mit ihrer Lötkante (6) auf einer Reihe von Anschlußbeinchen (3) auf und wird mit einer geringen Kraft (F1) an das am höchsten nach oben ragende Lotdepot (4) auf einem zugehörigen Anschlußflecken (5) angedrückt,
- die Temperatur am Lötort wird bis auf Schmelztemperatur (T2) erhöht und zeitweilig gehalten,
- während die Schmelztemperatur (T2) oder eine nachfolgende überhöhte Temperatur (T3) anliegt, wird die durch die Bügelelektrode (1) aufgebrachte Kraft in mehreren Stufen oder kontinuierlich bis zu einer maximalen Kraft (F24) erhöht, so daß über den zeitlichen Verlauf der Krafterhöhung eine auf die Anzahl der gleichzeitig niedergedrückten Anschlußbeinchen (3) bezogene gleichbleibende Andruckkraft erzeugt wird, und
- vor dem Absenken der maximal anliegenden Temperatur wird die maximal aufgebrachte Kraft bis auf eine Restkraft (F3) abgesenkt und gehalten, bis der Erstarrungsprozeß abgeschlossen ist, so daß Spannungen im noch nicht erstarrten Lot (4) abgebaut werden können.

2. Verfahren nach Anspruch 1,
**dadurch gekennzeichnet,**
daß die Temperatur am Lötort und die von der Bügelelektrode (1) aufgebrachte Kraft geregelt sind, so daß geradlinige Temperatur/Zeit- und Kraft/Zeit-Verläufe erzielt werden.

## Claims

1. Method for soldering surface-mountable electronic components having terminal legs (3) on printed circuit boards (2), use being made of at least one soldering device which contains a rigid iron electrode (1) for reflow soldering, which electrode can be heated by electrical resistance heat, can be moved upwards and downwards perpendicularly to the row of terminal legs and via which a pressure force acting on the terminal legs (3) of the component and directed at associated pads (5) is applied in a regulated manner as a function of the temperature at the soldering location, having the following steps:
- the yoke electrode (1) is placed by its soldering edge (6) on a row of terminal legs (3) and is pressed with a small force (F1) onto the highest upwardly projecting solder deposit (4) on an associated pad (5),
- the temperature at the soldering location is increased to the melting temperature (T2) and temporarily held,
- while the melting temperature (T2) or a subsequent excessive temperature (T3) is present, the force applied by the yoke electrode (1) is increased in a plurality of steps or continuously up to a maximum force (F24), thereby producing a constant pressure force, referring to the number of terminal legs (3) pressed down simultaneously, over the time characteristic of the force increase, and
- before the maximum temperature present is reduced, the maximum applied force is reduced down to a residual force (F3) and held until the solidification process is concluded, thereby enabling stresses in the as yet unsolidified solder (4) to be relieved.

2. Method according to Claim 1, characterized in that the temperature at the soldering location and the force applied by the yoke electrode (1) are regulated to obtain linear temperature/time and force/time characteristics.

## Revendications

1. Méthode de soudage de composants électroniques pourvus de pattes de connexion (3) pour montage à la surface de plaques de circuits (2), au moins un appareil à souder étant utilisé, lequel appareil comprend une électrode en étrier (1) fixe, pouvant être chauffée par la chaleur de résistances électriques et mobile vers le haut et vers le bas perpendiculairement à la rangée des pattes de connexion en vue d'un soudage par refusion, et grâce à laquelle une force de pression agissant sur les pattes de connexion (3) du composant et dirigée sur des points de liaison (5) associés est appliquée en subissant un réglage en fonction de la température à l'endroit de la soudure, comprenant les étapes suivantes :
- l'électrode en étrier (1) est posée, avec son arête de soudage (6), sur une rangée de pattes de connexion (3) et est pressée, avec une force réduite (F1), sur le dépôt de soudure (4) saillant le plus loin vers le haut, sur un point de liaison (5) associé,
- la température à l'endroit de la soudure est augmentée jusqu'à la température de fusion (T2) et est temporairement maintenue,
- pendant que la température de fusion (T2) ou une température surélevée (T3) consécutive est appliquée, la force appliquée par l'électrode en étrier est augmentée par paliers ou de manière continue jusqu'à une force maximum (F24) de manière à ce qu'une force de pression constante par rapport au nombre de pattes de connexion (3) enfoncées simultanément soit produite grâce à la variation dans le temps de l'augmentation de la force, et
- avant la chute de la température maximum appliquée, la force maximum appliquée est réduite jusqu'à l'obtention d'une force résiduelle (F3) et est maintenue jusqu'à ce que le processus de solidification soit achevé, de manière à pouvoir supprimer les tensions dans l'étain à souder (4) pas encore solidifié.

2. Méthode selon la revendication 1, caractérisée en ce que la température à l'endroit de la soudure et la force appliquée par l'électrode en étrier (1) sont réglées de manière à ce que l'on obtienne des courbes température/temps et force/temps d'allure rectiligne.
